Europäisches Patentamt

European Patent Office

Office européen des brevets

(19)

(11) **EP 0 967 844 B1**

(12) **FASCICULE DE BREVET EUROPEEN**

(45) Date de publication et mention
de la délivrance du brevet:
**14.09.2005 Bulletin 2005/37**

(51) Int Cl.⁷: **H05H 1/18**, H01J 37/32

(21) Numéro de dépôt: **99401545.1**

(22) Date de dépôt: **22.06.1999**

(54) **Procédé de dépôt par plasma à la résonance cyclotron électronique de couches de carbone émetteur d'électrons sous l'effet d'un champ électrique appliqué**

Verfahren zur EZR-Plasma Beschichtung mit Kohlenstoff-Filmen welche unter Einwirkung eines elektrischen Feldes Elektronenemission aufweisen.

Method for ECR plasma deposition of carbon layers which provide electron emission under the effect of an applied electric field

(84) Etats contractants désignés:
**DE GB IT**

(30) Priorité: **24.06.1998 FR 9807993**

(43) Date de publication de la demande:
**29.12.1999 Bulletin 1999/52**

(73) Titulaire: **COMMISSARIAT A L'ENERGIE ATOMIQUE**
**75752 Paris Cédex 15 (FR)**

(72) Inventeurs:
• **Delaunay, Marc**
**38240 Meylan (FR)**
• **Semeria, Marie-Noëlle**
**38250 St. Nizier du Moucherotte (FR)**

(74) Mandataire: **Audier, Philippe André et al Brevalex,**
**3, rue du Docteur Lancereaux**
**75008 Paris (FR)**

(56) Documents cités:
**US-A- 5 358 741**

• **PATENT ABSTRACTS OF JAPAN vol. 095, no. 001, 28 février 1995 (1995-02-28) & JP 06 280019 A (SEKISUI CHEM CO LTD), 4 octobre 1994 (1994-10-04)**

• **PATENT ABSTRACTS OF JAPAN vol. 016, no. 076 (C-0914), 25 février 1992 (1992-02-25) & JP 03 267375 A (SHIMADZU CORP;OTHERS: 02), 28 novembre 1991 (1991-11-28)**
• **PATENT ABSTRACTS OF JAPAN vol. 017, no. 001 (C-1014), 5 janvier 1993 (1993-01-05) & JP 04 238897 A (TOYOTA MOTOR CORP), 26 août 1992 (1992-08-26)**
• **DATABASE WPI Section Ch, Week 8723 Derwent Publications Ltd., London, GB; Class E36, AN 87-160935 XP002096290 & JP 62 096397 A (ASAHI CHEM IND CO LTD), 2 mai 1987 (1987-05-02)**
• **PATENT ABSTRACTS OF JAPAN vol. 012, no. 312 (C-523), 24 août 1988 (1988-08-24) & JP 63 083271 A (CANON INC), 13 avril 1988 (1988-04-13)**
• **TCHEREPANOV A Y ET AL: "FLAT PANEL DISPLAY PROTOTYPE USING LOW-VOLTAGE CARBON FIELD EMITTERS" JOURNAL OF VACUUM SCIENCE AND TECHNOLOGY: PART B, vol. 13, no. 2, 1 mars 1995 (1995-03-01), pages 482-486, XP000508565**
• **DATABASE WPI Section Ch, Week 9414 Derwent Publications Ltd., London, GB; Class E36, AN 94-115559 XP002096291 & JP 06 065744 A (SEKISUI CHEM IND CO LTD) , 8 mars 1994 (1994-03-08)**
• **W. Varhue and P. Pastel, J. Mater. Res. 5 (11), 2441-2444, (1990).**
• **B. Meyerson and F. W. Smith, J. Non-Cyst. Sol., 35/36, 435-440 (1980).**

**Description**

Domaine technique

La présente invention concerne un procédé de dépôt par plasma à la résonance cyclotron électronique de couches de carbone émetteur d'électrons sous l'effet d'un champ électrique appliqué.

Etat de la technique antérieure

Les couches de carbone émettrices d'électrons peuvent être logiquement classées suivant les trois structures suivantes : diamant, DLC (« Diamond Like Carbon ») et graphite. En réalité, une couche déposée peut contenir des structures mixtes, par exemple :

- des couches de cristaux de diamant avec des inclusions de graphite ;
- des couches de cristaux de graphite avec des inclusions de diamant.

Cette classification correspond alors à la structure principale.

Dans les dispositifs de l'art connu, indépendamment de l'émission d'électrons, des efforts particuliers de recherche ont été réalisés dans les domaines :

- de la synthèse de couches de diamant pour les propriétés mécaniques, optiques et électriques du diamant, à des températures comprises généralement entre 400°C et 1000°C ;
- de la réalisation de couches de carbone de type DLC (« Diamond Like Carbon »), généralement à basse température (20-400°C) et à fort taux de liaisons C-C sp$_3$, en particulier pour les propriétés mécaniques. De telles couches sont principalement amorphes.

Le tableau I, situé en fin de description, présente différents dispositifs et procédés de dépôts sous vide de couches de carbone utilisés actuellement pour le carbone émissif. Les dispositifs et procédés considérés sont décrits dans des documents référencés en fin de description.

Dans ce tableau on met en évidence deux mécanismes de dépôt :

- un dépôt de type « CVD » ou « Chemical Vapor Deposition », dans lequel un gaz de molécules organiques (souvent du méthane) est introduit en mélange, avec ou sans hydrogène, dans un dispositif permettant de rompre les liaisons C-C, C-H et H-H par impact électronique avec, par exemple, l'utilisation d'un filament chaud, l'introduction d'une puissance micro-onde, l'utilisation d'une polarisation radio-fréquence (RF) ou l'utilisation d'une résonance cyclotron électronique (RCE). Suivant le dispositif utilisé, la pression de fonctionnement est forte (filament, micro-ondes, radio-fréquence) ou faible (RCE, RF). Il en résulte une dissociation et une ionisation des particules d'autant plus importante que la pression est faible. L'énergie à fournir pour réaliser la réaction de transformation du gaz en solide est fortement diminuée par les ruptures de liaisons covalentes (par exemple CH$_4$) des molécules organiques. Il est ainsi possible d'obtenir des structures cristallisées (graphite ou diamant) à des températures de substrat plus faibles (par exemple 400°C au lieu de 800°C). La polarisation du substrat permet également de favoriser la cristallisation à plus basse température permettant l'utilisation d'une plus grande variété de substrats ;
- un dépôt direct d'atomes ou d'ions de carbone, qui peut être effectué par pulvérisation d'une cible de graphite, par arc, par ablation laser, faisceau d'ions ou par évaporation. La qualité et la structure des couches dépendent essentiellement de l'énergie des ions ou des atomes de carbone incidents pour une température donnée.

Les couches minces de carbone, étudiées pour leurs propriétés d'émission d'électrons par effet de champ dans les dispositifs de l'art connu, correspondent à une des trois couches suivantes :

- une couche de cristaux de diamant avec un taux de structure amorphe et graphitique non négligeable (le diamant « pur » ne semble pas émettre) : le problème principal est alors la réalisation d'un dépôt à basse température sur de grandes surfaces. Une contrainte importante réside dans l'utilisation d'une proportion très faible (1 %) de méthane (ou d'autres molécules organiques) par rapport à une quantité importante d'hydrogène utile à la croissance du diamant, avec une température minimale de 400°C. Une étape de réalisation de sites précurseurs est souvent nécessaire ;
- une couche de carbone DLC à fort taux de liaison C-C sp$_3$ : une contrainte importante réside alors dans l'énergie nécessaire des ions ou atomes de carbone incident (de l'ordre de 100 eV) pour réaliser de telles couches. Certains dispositifs, intrinsèquement, ne peuvent pas réaliser des dépôts sur de grandes dimensions (ablation laser, arc).

Pour les dispositifs RF (radio-fréquence), cette possibilité reste à démontrer ;
- une couche de graphite variée, avec ou sans inclusion de cristaux de diamant.

Un procédé de dépôt par plasma à la résonance cyclotron électronique de couches de carbone est décrit dans JP-032767375 (diamant), JP-06280019 (DLC) et JP-62096397 (diamant).

Dans un procédé de dépôt de telles couches de carbone émettrices, on a les contraintes techniques suivantes :

- ces couches émettrices d'électrons doivent être réalisées sur de grandes surfaces (possibilité à 1m$^2$) à faible coût et avec une bonne homogénéité de dépôt et d'émission ;
- La température du dépôt doit être inférieure à 600°C pour l'utilisation de substrats de verre standard ;
- le champ seuil d'émission, défini comme le champ électrique à appliquer pour mesurer un courant d'électrons de 0.1 µA, doit être faible (de l'ordre de 10 V/µm), avec éventuellement un abaissement de ce seuil par dopage ;
- les couches de carbone doivent être stables lors des différentes étapes de fabrication d'un écran, en particulier lors des différents recuits, et lors du fonctionnement de l'écran, l'émission de la couche étant alors activée par un champ électrique.

La présente invention a pour objet un procédé de dépôt par plasma à la résonance cyclotron électronique de couches de matériau émetteur d'électrons sous l'effet d'un champ électrique appliqué, qui puisse être appliqué à de grandes surfaces, typiquement de l'ordre de 1 m$^2$. La présente invention correspond au dernier type de structure défini ci-dessus, avec un taux de liaisons C-C sp$_3$ typiquement de 10 à 30 % réalisé à température moyenne (de 300°C - 800°C) et à basse pression (environ $5 \times 10^{-4}$ mbar) par procédé CVD.

La présente invention décrit un procédé de dépôt pour l'obtention de couches émettrices d'électrons, sachant qu'une phase préalable de préparation de substrat peut être ajoutée dans le but de favoriser l'adhérence de la couche ou de modifier le type de liaisons l'interface.

Cette phase préalable peut comprendre une étape de pulvérisation ou une étape de dépôt avec des conditions spécifiques de polarisation, de pression et un choix adéquat d'un ou de plusieurs gaz.

Exposé de l'invention

La présente invention concerne un procédé de dépôt par plasma à la résonance cyclotron électronique de couches électriquement conductrices de carbone, les couches de carbones étant des couches de carbones émetteur d'électrons sous l'effet d'un champ électrique appliqué, et le carbone étant de type graphitique avec une proportion minoritaire de liaisons sp$_3$, dans lequel, par injection d'une puissance micro-onde dans une chambre à plasma comprenant une zone de résonance cyclotron électronique, on produit l'ionisation d'un mélange gazeux, comprenant des molécules organiques et des molécules d'hydrogène, sous une pression faible de 10$^{-4}$ à 10$^{-3}$ mbar, les ions et les électrons ainsi créés diffusant le long de lignes de champ magnétique jusqu'à un substrat, ledit procédé comprenant de plus les étapes suivantes :

- de chauffage du substrat ;
- de création d'un plasma à partir du mélange gazeux ionisé pour une valeur du champ magnétique correspondant à la résonance cyclotron électronique des molécules organiques ;
- de création d'une différence de potentiel positive entre le substrat et le plasma, le substrat étant polarisé positivement par rapport au plasma, une polarisation positive ou nulle étant appliquée au substrat ;
- de diffusion du plasma jusqu'au substrat, ledit substrat ayant atteint, par chauffage, une température telle que soit obtenu sur le substrat le dépôt dudit matériau émetteur d'électrons, la température du substrat étant comprise entre 300°C et 800°C.

Dans un mode de réalisation avantageux ces différentes étapes sont réalisées simultanément.

Avantageusement les couches de carbone sont constituées d'une matrice de graphite avec inclusion de cristaux de diamant.

Le chauffage du substrat peut être réalisé par bombardement électronique, ou par un dispositif de chauffage externe. Le gaz organique peut être du méthane, du méthanol ou de l'acétylène.

Avantageusement l'injection de la puissance micro-onde a lieu à la fréquence de 2,45 GHz. Le substrat peut être polarisé positivement entre typiquement +50 Volts et +200 Volts. Avantageusement le plasma est polarisé par la chambre à plasma à -50 Volts, le substrat étant mis à la masse.

On peut faire varier la proportion de molécules organiques par rapport à l'hydrogène dans le mélange gazeux de quelques % à 100 %.

Le substrat peut être en silicium, en silicium recouvert d'une couche conductrice, par exemple en molybdène, ou en verre standard recouvert d'une couche conductrice, par exemple en molybdène.

Une des principales applications du procédé de l'invention est celui de la réalisation d'écrans plats à effet de champ, de grandes dimensions, où le carbone agit comme une source d'électrons, remplaçant avantageusement les micro-pointes métalliques.

Brève description des dessins

- La figure 1 illustre un premier type de source de plasma à résonance cyclotron électronique à bobines rectangulaires permettant de mettre en oeuvre le procédé de l'invention, le substrat étant en défilement suivant une dimension ;
- la figure 2 illustre un second type de source de plasma à résonance cyclotron électronique permettant un dépôt direct de grandes dimensions, sans défilement du substrat ;
- la figure 3 illustre la zone de résonance cyclotron électronique dans la source illustrée sur la figure 2, créé par des bobines de champ magnétique de grandes dimensions ;
- la figure 4 illustre un troisième type de source de plasma à résonance cyclotron électronique, utilisant des aimants permanents et un défilement du substrat suivant une dimension.

Exposé détaillé de modes de réalisation

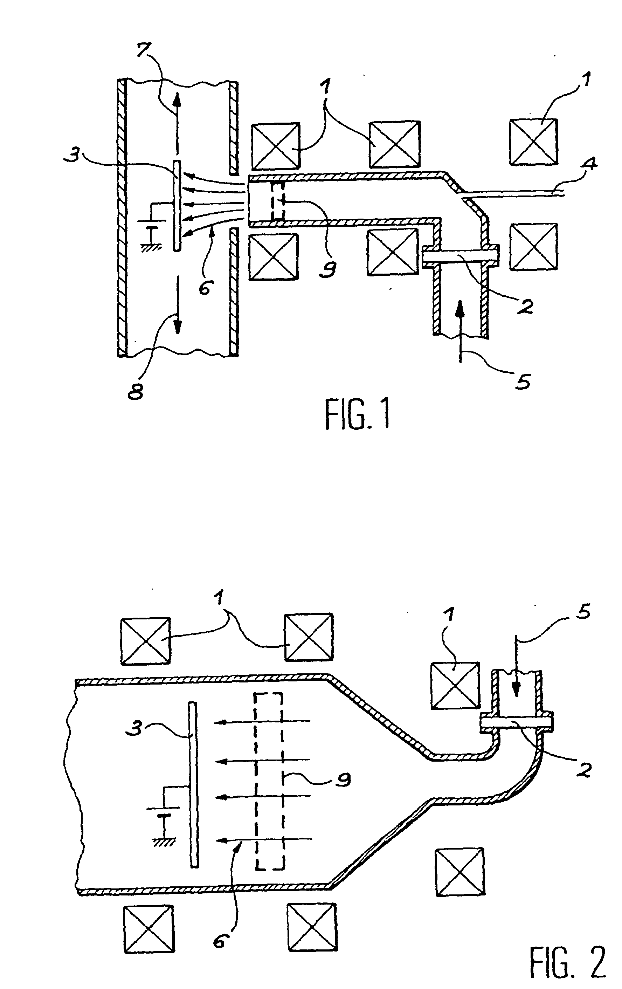

La figure 1 illustre une source à plasma de résonance cyclotron électronique (RCE) à bobines rectangulaires dans une vue de dessus.

Sur cette figure est illustrée une chambre à plasma avec des bobines rectangulaires 1, une fenêtre micro-onde 2, un substrat 3, qui est polarisé positivement, une canalisation d'injection du mélange gazeux 4. Sont également représentés par des flèches : l'injection micro-onde 5, la diffusion du plasma 6, le défilement du substrat 7, le pompage 8. La zone 9 est la zone de RCE.

Une telle source permet de mettre en oeuvre le procédé de l'invention.

La présente invention concerne, ainsi, un procédé de dépôt par plasma cyclotron électronique de couches électriquement conductrice de carbone, les couches de carbones étant des couches des carbones émetteur d'électrons sous l'effet d'un champ électrique appliqué, le carbone étant de type graphitique avec une proportion minoritaire de liaisons sp3, dans lequel, par injection d'une puissance micro-onde dans la chambre à plasma comprenant une zone de résonance cyclotron électronique, on produit l'ionisation du mélange gazeux, le mélange gazeux comprenant des molécules organiques et des molécules d'hydrogène, sous une pression faible de $10^{-4}$ à $10^{-3}$ mbar, les ions et les électrons ainsi créés diffusant le long des lignes de champ magnétique 6 jusqu'au substrat 3, ledit procédé comprenant de plus des étapes :

- de chauffage du substrat 3 ;
- de création d'un plasma à partir du mélange gazeux ionisé pour une valeur du champ magnétique correspondant à la résonance cyclotron électronique des molécules organiques ;
- de création d'une différence de potentiel positif entre le plasma et le substrat, le substrat étant polarisé positivement par rapport au plasma, une polarisation positive ou nulle étant appliquée au substrat ;
- de diffusion du plasma jusqu'au substrat 3, ledit substrat ayant atteint, par chauffage, une température telle que soit obtenu sur le substrat le dépôt dudit matériau émetteur d'électrons, la température du substrat étant comprise entre 300°C et 800°C.

Ces différentes étapes peuvent, avantageusement, être réalisées simultanément.

Dans le plasma, il y a des espèces neutres ($CH_3$, CH, C...) et des espèces ionisées ($CH^+_3$, $CH^+$, ...$C^+$...)

L'introduction de la puissance micro-onde (avantageusement à la fréquence de 2.45 GHz) dans la chambre à plasma située à l'intérieur d'une structure magnétique adéquate (comme décrite dans le document référencé [11] en fin de description) produit l'ionisation de molécules organiques et d'hydrogène que l'on introduit à une pression faible.

L'ionisation a lieu dans la zone correspondant au champ magnétique de résonance ($875 0^{-4}$ T (875 Gauss) si la fréquence de l'onde est de 2.45 GHz) et le plasma ainsi créé diffuse le long des lignes de champ magnétique jusqu'au substrat polarisé positivement (typiquement de +50 Volts à +200 Volts). La dissociation des molécules $CH_4$ et $H_2$ a donc lieu dans le plasma et sur le substrat (bombardement électronique énergétique). L'intérêt d'utiliser un plasma RCE à basse pression est l'obtention d'une rupture des liaisons C-H, C-C et C-H importante (pour obtenir des atomes H° réactifs par exemple et des atomes C°) afin de réaliser des couches de graphite (avec inclusion de cristaux de diamant) à la plus basse température possible.

Le dépôt est réalisé à faible pression (typiquement une pression inférieure à $8 \times 10^{-4}$ mbar) d'hydrogène et de gaz organique (méthane, méthanol, ou toute molécule organique) permettant la réalisation d'écrans plats de grandes surfaces (de 1/4 à 1 $m^2$).

Le dispositif utilisé est alors une source de plasma de grandes dimensions à la résonance cyclotron électronique construite avec des bobines de champ magnétique parcourues par un courant ou par des aimants permanents.

Le substrat, situé dans la zone de diffusion du plasma, est polarisé positivement principalement afin de compléter la dissociation des molécules organiques et d'hydrogène sur le substrat.

Le chauffage du substrat a pour objet d'augmenter la diffusion des atomes et la cristallisation.

Le plasma peut, également et avantageusement, être polarisé à -50 Volts, le substrat étant mis à la masse pour un défilement du substrat simplifié.

Les proportions de méthane ou de molécules organiques introduites par rapport à l'hydrogène peuvent varier de quelques % à 100 %, le champ seuil étant d'autant plus faible que la proportion de méthane ou de molécules organiques est plus faible.

Le chauffage du substrat peut être réalisé par le bombardement électronique (polarisation positive), ou par un système externe (par exemple un filament). La gamme de température 300°C à 800°C permet un dépôt sur des substrats de verre pour les écrans plats.

L'épaisseur des couches peut varier de quelques $10^{-7}$ m à quelques micromètres sur différents substrats conducteurs ou semi-conducteurs : par exemple en silicium, en silicium recouvert d'une couche conductrice, par exemple de molybdène, en verre standard recouvert d'une couche conductrice, par exemple de molybdène.

Le procédé de l'invention permet ainsi de synthétiser et d'utiliser des couches de graphite conducteur réalisées par plasma à la résonance cyclotron électronique (RCE) à basse pression et à moyenne température (300°C-800°C) .

Dans le tableau II, quelques exemples de couches émettrices illustrent le domaine de réalisation du procédé de l'invention (sans dopage). Les champs seuil d'émission d'électrons sont semblables pour des substrats de silicium et des substrats de silicium recouverts d'une couche conductrice, par exemple de molybdène. Contrairement à la synthèse de couches de diamant qui nécessite de faibles proportions de $CH_4/H_2$ (0,5 à 2 % en général), dans le procédé de l'invention la proportion $CH_4/H_2$ peut être comprise entre quelques % et 100 %, le champ seuil étant d'autant plus faible que le rapport $CH_4/H_2$ est faible.

Des dispositifs de plasma micro-onde à la résonance cyclotron électronique pour déposer de telles couches de carbone sur de grandes surfaces sont représentés dans le tableau III en fin de description.

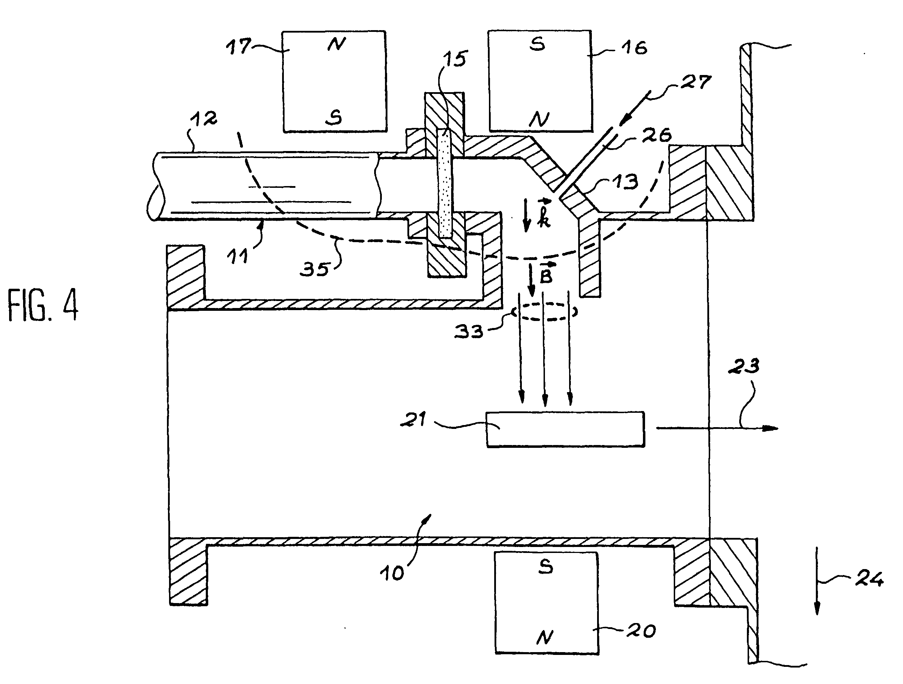

Il est nécessaire de distinguer les dispositifs de dépôt avec défilement du substrat (nappes de plasma longues et étroites comme illustré sur la figure 1) des systèmes permettant directement un dépôt de grandes dimensions, comme illustré sur la figure 2, dans laquelle les références utilisées sur les figures 1 et 4 ont été conservées.

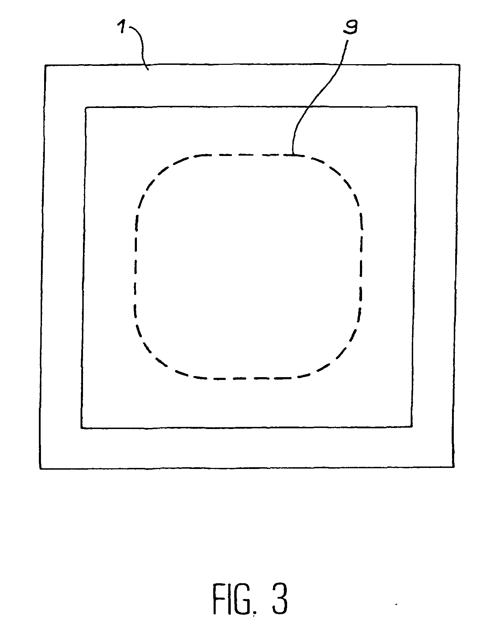

Sur la figure 3 est illustrée la zone de résonance cyclotron électronique, entre deux bobines carrées par exemple de spires intérieures $60 \times 60$ $cm^2$, cette zone de résonance cyclotron électonique étant alors homogène sur une surface S ~ $40 \times 40$ $cm^2$.

Les dimensions du dépôt dépendent principalement de la surface de champ magnétique de résonance cyclotron électronique réalisable avec des solénoïdes, des bobines de champ magnétique rectangulaires ou carrées, comme décrit dans le document référencé [4], ou des aimants permanents. Le plasma diffuse de la zone de résonance cyclotron électronique jusqu'au substrat en suivant les lignes de champ magnétique (très peu de collisions ont lieu à ces faibles pressions dans la diffusion) . Le flux magnétique est conservatif. Pour un champ magnétique constant ($B_{substrat}$ ~ $B_{RCE}$), la surface homogène de dépôt est sensiblement égale à la surface de résonance cyclotron électronique.

Si l'on diminue le champ $B_{substrat}$, la surface de dépôt homogène augmente avec la densité de plasma qui diminue.

Les dispositifs considérés ont avantageusement des fenêtres d'étanchéité micro-ondes situées à 90° en dehors de l'axe du plasma pour éviter tout recouvrement possible des fenêtres micro-ondes et permettre un fonctionnement continu du dispositif.

Dans le dispositif à bobines de champ magnétique rectangulaires, illustré sur la figure 1, on peut obtenir une hauteur de plasma de 25 cm qui peut être étendue à un mètre si nécessaire. La zone de résonance cyclotron électronique est créée à l'extrémité du guide d'onde sous vide. Le maximum de champ magnétique est de 0.25 Tesla au niveau de l'injection (coude et fenêtre micro-ondes) et décroît jusqu'à la résonance cyclotron électronique à 0.0875 Tesla. L'inconvénient principal de ce dispositif est la forte consommation électrique (de 20 à 40 kWatts).

Dans le dispositif illustré sur la figure 2, on utilise des solénoides carrés circulaires de 40 cm de côté permettant un dépôt direct d'environ $40 \times 40$ $cm^2$ sans défilement. L'injection micro-onde est de type cornet de transition avec un changement de section par exemple de S1 = 8 cm $\times$ 8 cm à S2 = 50 cm $\times$ 50 cm ou par la juxtaposition de plusieurs guides élémentaires. L'inconvénient principal de ce dispositif est la forte consommation électrique (de 30 à 80 kWatts).

Les dépôts avec défilement réalisés avec un système totalement en aimants permanents sont illustrés sur la figure 4. Sur cette figure la source à plasma est constituée d'une enceinte à vide 10, d'un ensemble d'aimants permanents 16, 17 et 20 créant une configuration magnétique donnée et générant une nappe de plasma dans l'enceinte, et d'un coupleur 11 répartissant dans l'enceinte la puissance générée par un ou plusieurs émetteurs micro-ondes. Cette injection de puissance dans l'enceinte 10 produit l'ionisation d'un gaz sous faible pression. Une canalisation 26 permet l'injection de ce gaz 27.

Le coupleur 11 comprend un guide d'injection micro-onde 12 se terminant par un coude 13 à 90° qui est connecté à l'enceinte 10 perpendiculairement à celle-ci. Une fenêtre micro-onde d'étanchéité 15, par exemple en quartz, est disposée entre le guide d'onde d'admission 12 et le coude 13.

La zone de résonance cyclotron électronique est représentée par une ligne en tiretés 35, la valeur de cette résonance étant égale à RCE1 dans le guide d'injection micro-onde 12, qui est un guide à l'air, et RCE2 dans le coude 13, qui est sous vide, la flèche 24 illustrant le pompage dans l'enceinte 10.

Un substrat 21 polarisé positivement ou à la masse est situé dans le plasma de diffusion. Ce substrat 21, mû par exemple d'un déplacement rectiligne 23, peut être refroidi grâce à un circuit de refroidissement.

Le premier et le second aimants permanents 16 et 17 sont disposés de part et d'autre de la fenêtre 15. Ces aimants 16 et 17 sont installés avec une alternance de pôle N-S (Nord-Sud) ou S-N (Sud-Nord).

Le premier aimant 16 crée un champ magnétique $\vec{B}$ parallèle à la propagation micro-onde $\vec{k}$. Il crée un champ de module RCE2 dans le coude 13 situé en aval jusqu'au lieu désiré. Combiné au second aimant 17, il crée un fort champ au niveau de la fenêtre 15.

Le troisième aimant 20 est disposé de l'autre côté de la cavité 10, au même niveau que le premier aimant 16. Il est utilisé pour ramener les lignes de champ sur le substrat 21 et augmenter ainsi la densité ionique de pulvérisation. Ainsi les lignes de champ magnétique convergent vers le substrat 21 pour obtenir la densité d'ions la plus élevée possible sur celle-ci : la diffusion du plasma 33 suit les lignes de champ magnétique et la densité de courant est approximativement proportionnelle au champ magnétique (le flux magnétique et le courant total se conservent le long de la diffusion). S'il n'y avait pas de reprise de flux grâce à ce troisième aimant 20, les lignes de champ divergeraient et ainsi la densité de plasma diminuerait.

L'injection d'une puissance micro-onde dans le guide d'onde 12 à travers la fenêtre d'étanchéité 15 produit l'ionisation du gaz dans la zone 35 de résonance cyclotron électronique située à quelques centimètres à l'intérieur du coude 13 sous vide. Le plasma ainsi créé diffuse le long des lignes de champ magnétique jusqu'au substrat 21 (polarisé de +50 à +200 Volts typiquement). Les électrons sont accélérés vers le substrat 21.

L'avantage principal de cette configuration réside dans son faible coût et sa très faible consommation électrique, liée uniquement au générateur micro-ondes.

Contrairement aux dispositifs à résonance cyclotron électronique généralement utilisés, les sources de plasma, considérées ci-dessus, sont simultanément de grandes dimensions, avec des fenêtres micro-ondes protégées (à 90°) et fonctionnent à faible pression pour augmenter la dissociation des molécules de méthane ou d'autres molécules organiques et d'hydrogène.

<u>REFERENCES</u>

[1] « Field Emission From P-Type Polycrystalline Diamond Films » de D. Hong et M. Aslam (Revue « Le Vide, les Couches Minces », Supplément au N° 271, Mars-avril 1994, pages 96 à 99)

[2] « Defect-Enhanced Electron Field Emission From Chemical Vapor Deposited Diamond » de W. Zhu, G.P. Kochanski, S. Jin et L. Seibles (Journal Applied Physics, 78(4), 15 août 1995, pages 270 et suivantes)

[3] « High-Sensitivity Absorption Spectroscopy On A Microwave Plasma-Assisted Chemical Vapour Deposition Diamond Growth Facility » de C.J. Erickson, W.B. Jameson, J. Watts-Cain, K.L. Menningen, M.A. Childs, L.W. Anderson et J.E. Lawler (Plasma Sources Sci. Technol. 5 (1996), pages 761-764)

[4] « Fabrication of Diamond Films at Low Pressure and Low-Temperature by Magneto-Active Microwave Plasma Chemical Vapor Deposition » de Takuya Yara, Motokazu Yuasa, Manabu Shimizu, Hiroshi Makita, Akimitsu Hatta, Jun-Ichi Suzuki, Toshimichi Ito et Akio Hiraki (pn. J. Appl. Phys., Vol. 33 (1994), pages 4404-4408, art 1, No. 7B, Juillet 1994)

[5] « Chemical Vapour Deposition Of Diamond in RF Glow Discharge » de Seiichiro Matsumoto (Journal of Materials Science Letters 4 (1985), pages 600-602)

[6] « Field Emission From Tetrahedral Amorphous Carbon » de B.S. Satyanarayana, A. Hart, W.I. Milne et J. Robertson (Appl. Phys. Lett. 71 (10), 8 septembre 1997, pages 1 à 3)

[7] "Nitrogen Containing Hydrogenated Amorphous Carbon For Thin-Film Field Emission Cathodes » de Gehan A. J. Amaratunga et S.R.P. Silva (Appl. Phys. Lett. 68 (18), 29 avril 1996, pages 2529 à 2531)

[8] « Electron Field Emission From Amorphous Carbon-Cesium Alloys » de S.P Bozeman, S.M. Camphausen, J.

J. Cuomo, S.I. Kim, Y.O. Ahn et Young Ko (J. Vac. Sci. Technol. A 15(3), mai/juin 1997, pages 1729 à 1732)

[9] « Electron Field Emission From Amorphous Tetrahedrally Bonded Carbon Films » de A.A. Talin, T.E. Felter, T. A. Friedmann, J.P. Sullivan et M.P. Siegal (J. Vac. Sci. Technol. A 14(3), mai/juin 1996, pages 1719 à 1722)

[10] « High Quality Diamond Like Carbon Thin Film Fabricated by ECR Plasma CVD » de K. Kuramoto, Y. Domoto, H. Hirano, S. Kiyama et S. Tsuda (Applied Surface Science 113/114 (1997), pages 227-230)

[11] « ECR Plasma Ion Source For Material Depositions » de M. Delaunày et E. Touchais (Rev. Of Sci. Instrum. Juin 1998, n° A97622)

[12] « Field Electron Emission From Highly Graphitic Diamond Film With Ball-Like Surface Morphologies » de Li Yunjun, He Jintian, Yao Ning et Zhang Binglin (Technical Digest of IVMC'97, Kyongju, Corée, 1997)

[13] « Flat Panel Displays Based Upon Low-Voltage Carbon Field Emitters » de A.Y. Tcherepanov, A.G. Chakhovskoi et V.V. Sharov (« Le Vide, les Couches Minces », supplément au N° 271, mars-avril 1994)

[14] « La télévision du futur se met à plat » de Jean-Michel Le Corfec (« Sciences et avenir », avril 1998, page 87)

## TABLEAU I

### Exemples de dépôts de couches de carbone

| | Dispositif | Référ. | Procédé | Tempér. Substrat (°C) | Pression (mbar) | % gaz | Champ seuil émission (V/μm) | Polaris. substrat (V) |
|---|---|---|---|---|---|---|---|---|
| **DIAMANT** | filament chaud | [1] | CVD (ou «Chemical Vapor Deposition») | 800 à 1000 | 30 à 50 | 1% $CH_4/H_2$ | 20 | |
| | micro-ondes | [2] | CVD | 800 | | 1% $CH_4$ $C_2H_5OH$ | 22 à 50 | |
| | micro-ondes | [3] | CVD | 650 à 1100 | 20 à 100 | 0,5 à 3% $CH_4$ | | 0 à -300 |
| | RCE | [4] | CVD | 300 à 500 | $2 \times 10^{-2}$ à 2 | $CH_3OH$ ou 0,5% $CH_4$ | | +30 |
| | RF (ou radio-fréquence) | [5] | CVD | 700 à 1200 | 20 à 30 | 0,2 à 1% $CH_4/H_2$ | | |
| **DLC ("Diamond Like Carbon")** | Arc | [6] | ions $C^+$ | 20 | P II | sans | 10 | 0 à -350 |
| | RF | [7] | PECVD | 20 | $10^{-3}$ à $3 \times 10$ | $CH_4$ ou 10% $CH_4$ avec He | 5 à 20 | -100 |
| | Source d'ions | [8] | Pulvérisation de carbone par ions $CO^+$ | 20 | | | 17 | |
| | Laser | [9] | Ablation →plasma de carbone | 20 | | | 10 | |
| | RCE | [10] | CVD | 20 à 100 | $10^{-3}$ à $10^{-2}$ | 20% à 100% $CH_4$ | | -50 à -500 |
| **GRAPHITE** | RCE | [11] | CVD | 400 à 600 | $6 \times 10^{-4}$ | $CH_4$ 10-50% $H_2$ | 10 à 30 | +100 |
| | Micro-ondes | [12] | CVD | 800 | 40 | 1% $CH_4$ 99% $H_2$ | 5 | |
| | Suie | [13] | Collage suie | 20 | | | 20 | |
| | Décharge électrique | [14] | CVD nanotubes | 900 | | $CH_4$ | | |

## TABLEAU II

### Exemples de couches émettrices réalisées dans le cadre de l'invention

| Pics Raman $cm^{-1}$ | % $CH_4$ | % H2 | Pression totale (mbar) | Polarisation substrat (V) | Température substrat (°C) | Substrat | Champ seuil ($\mu$ V/m) | Structure | Puissance micro-ondes (W) |
|---|---|---|---|---|---|---|---|---|---|
| 1346 | 5 | 95 | $7\times10^{-4}$ | + 100 | ~600 | Silicium | 10 | Graphite | 600 |
| 1580 * | 30 | 70 | $6\times10^{-4}$ | + 60 | ~500 | Mo/Si | 15 | Graphite « noir » | 800 |
| 1610 | 30 | 70 | $6\times10^{-4}$ | + 60 | ~400 | Mo/Si | 15 | Graphite « blanc » | 600 |

\* Structure graphitique

TABLEAU III

| Dispositifs de plasma à la résonance cyclotron électronique utilisés dans l'invention pour déposer des couches de carbone émettrices d'électrons par émission de champ | | | | |
|---|---|---|---|---|
| Dispositif | Dépôt | Référence | Géométrie de la section du plasma | Consommation électrique |
| Solénoïdes de grandes dimensions circulaires ou rectangulaires | Direct sans défilement du substrat | [11] Figure 2 | Disques ou rectangles de grandes dimensions | Importante 30-80 kw |
| Bobines rectangulaires allongées | avec défilement du substrat | [11] Figure 1 | Rectangles longs et étroits (nappes) | Moyenne 20kw |
| Aimants permanents | avec défilement du substrat | Figure 4 | Rectangles longs et étroits(nappes) | Faible (seulement micro-ondes) |

**Revendications**

1. Procédé de dépôt par plasma à la résonance cyclotron électronique de couches électriquement conductrices de carbone, les couches de carbones étant des couches de carbones émetteur d'électrons sous l'effet d'un champ électrique appliqué, et le carbone étant de type graphitique avec une proportion minoritaire de liaisons $sp_3$, dans lequel, par injection d'une puissance micro-onde dans une chambre à plasma comprenant une zone de résonance cyclotron électronique (9), on produit l'ionisation d'un mélange gazeux, comprenant des molécules organiques et des molécules d'hydrogène, sous une pression faible de $10^{-4}$ à $10^{-3}$ mbar, les ions et les électrons ainsi créés diffusant le long de lignes de champ magnétique (6) jusqu'à un substrat (3), ledit procédé comprenant de plus les étapes suivantes :

- de chauffage du substrat (3) ;
- de création d'un plasma à partir du mélange gazeux ionisé, pour une valeur du champ magnétique correspondant à la résonance cyclotron électronique des molécules organiques ;
- de création d'une différence de potentiel positive entre le plasma et le substrat, le substrat étant polarisé positivement par rapport au plasma, une polarisation positive ou nulle étant appliquée au substrat ;
- de diffusion du plasma jusqu'au substrat (3), ledit substrat ayant atteint, par chauffage, une température telle que soit obtenu sur le substrat le dépôt dudit matériau émetteur d'électrons, la température du substrat étant comprise entre 300°C et 800°C.

2. Procédé selon la revendication 1, dans lequel les couches de carbone sont constituées d'une matrice de graphite avec inclusion de cristaux de diamant.

3. Procédé selon la revendication 1, dans lequel le chauffage du substrat est réalisé par bombardement électronique ou par un dispositif de chauffage externe.

4. Procédé selon la revendication 1, dans lequel le gaz organique est du méthane, du méthanol, ou de l'acétylène.

5. Procédé selon la revendication 1, dans lequel l'injection de la puissance micro-onde a lieu à la fréquence de 2,45 GHz.

6. Procédé selon la revendication 1, dans lequel le substrat est polarisé entre +50 Volts et +200 Volts.

7. Procédé selon la revendication 1, dans lequel le plasma est polarisé à -50 Volts, le substrat étant mis à la masse.

8. Procédé selon la revendication 1, dans lequel la proportion de molécules organiques par rapport à l'hydrogène dans le mélange gazeux est comprise entre quelques % et 100 %.

9. Procédé selon la revendication 1, dans lequel le substrat est en silicium, en silicium recouvert d'une couche de molybdène, ou en verre standard recouvert d'une couche de molybdène.

10. Procédé selon l'une quelconque des revendications précédentes, qui est utilisé pour la réalisation d'écrans plats de grandes dimensions.

**Patentansprüche**

1. Verfahren zur EZR-Plasma-Abscheidung von elektrisch leitfähigen Kohlenstoffschichten, wobei diese Kohlenstoffschichten Schichten sind, die unter Einwirkung eines elektrischen Feldes Elektronen emittieren und der Kohlenstoff vom Graphit-Typ mit einem geringen Anteil von $sp_3$-Bindungen ist, und bei dem man durch Einspeisung einer Mikrowellenleistung in eine Plasmakammer mit einer Elektronenzyklotronresonanz-Zone (9) die Ionisierung eines unter einem schwachen Druck von $10^{-4}$ bis $10^{-3}$ mbar stehenden und organische Moleküle und Wasserstoffmoleküle enthaltenden Gasgemisches bewirkt, wobei die so erzeugten Elektronen und Ionen längs der Magnetfeldlinien (6) bis zu einem Substrat (3) diffundieren und das genannte Verfahren dabei zudem die folgenden Schritte umfasst:

- Heizen des Substrats (3);
- Erzeugen eines Plasmas aus dem ionisierten Gasgemisch für einen Wert des Magnetfelds, welcher der Elektronenzyklotronresonanz der organischen Moleküle entspricht;
- Herstellen einer positiven Potentialdifferenz zwischen dem Plasma und dem Substrat, indem das Substrat bezüglich des Plasmas positiv polarisiert bzw. vorgespannt wird, die an das Substrat angelegte Vorspannung positiv oder null ist;

**EP 0 967 844 B1**

- Diffundieren des Plasmas bis zu dem Substrat (3), wobei das genannte Substrat durch Heizen eine solche Temperatur erreicht, dass man auf dem Substrat die Abscheidung des genannten elektronenemittierenden Materials erhält, wobei die Temperatur des Substrats zwischen 300 °C und 800 °C enthalten ist.

2. Verfahren nach Anspruch 1, bei dem die Kohlenstoffschichten durch eine Graphitmatrix mit Diamantkristalleinschlüssen gebildet wird.

3. Verfahren nach Anspruch 1, bei dem das Heizen des Substrats durch Elektronenbeschuss oder durch eine externe Heizvorrichtung realisiert wird.

4. Verfahren nach Anspruch 1, bei dem das organische Gas Methan, Methanol oder Acetylen ist.

5. Verfahren nach Anspruch 1, bei dem die Einspeisung der Mikrowellenleistung mit einer Frequenz von 2,45 GHz stattfindet.

6. Verfahren nach Anspruch 1, bei dem das Substrat mit zwischen +50 Volt und +200 Volt polarisiert bzw. vorgespannt wird.

7. Verfahren nach Anspruch 1, bei dem das Plasma mit -50 Volt polarisiert wird.

8. Verfahren nach Anspruch 1, bei dem der Anteil der organischen Moleküle in Bezug auf den Wasserstoff in dem Gasgemisch zwischen einigen % und 100 % enthalten ist.

9. Verfahren nach Anspruch 1, bei dem das Substrat aus Silicium, aus mit einer Molybdänschicht überzogenem Silicium oder aus mit einer Molybdänschicht überzogenem Standard-Glas ist.

10. Verfahren nach einem der vorangehenden Ansprüche, das zur Herstellung flacher Bildschirme mit großen Abmessungen angewendet wird.

**Claims**

1. Process for the deposition by electron cyclotron resonance of electrically conductive carbon layers, the latter being electron emitter carbon layers under the effect of an applied electric field, the carbon being of the graphite type with a minority proportion of $sp_3$ bonds, in which, by the injection of a microwave power into the plasma chamber comprising an electron cyclotron resonance zone ionization of the gaseous mixture is brought about, said gaseous mixture comprising organic molecules and hydrogen molecules, under a low pressure of $10^{-4}$ to $10^{-3}$ mbar, the ions and electrons created in this way diffusing along the magnetic field lines 6 up to the substrate 3, said process also comprising the following stages:

- the heating of substrate 3,
- creating a plasma from the ionized gaseous mixture for a value of the magnetic field corresponding to the electron cyclotron resonance of the organic molecules,
- creating a positive potential difference between the plasma and the substrate, the substrate being positively polarized with respect to the plasma, a positive or zero polarization being applied to the substrate,
- diffusion of the plasma up to the substrate 3, said substrate having reached, by heating, a temperature such that on the substrate deposition takes place of said electron emitter material, the substrate temperature being between 300 and 800°C.

2. Process according to claim 1, wherein the carbon films are constituted by a graphite matrix with the inclusion of diamond crystals.

3. Process according to claim 1, wherein substrate heating takes place by electron bombardment or by an external heating device.

4. Process according to claim 1, wherein the organic gas is methane, methanol or acetylene.

5. Process according to claim 1, wherein the microwave power is injected at a frequency of 2.45 GHz.

6. Process according to claim 1, wherein the substrate is polarized between +50 and +200 Volt.

7. Process according to claim 1, wherein the plasma is polarized at -50 Volt, the substrate being earthed.

8. Process according to claim 1, wherein the proportion of organic molecules compared with hydrogen in the gaseous mixture is between a few % and 100%.

9. Process according to claim 1, wherein the substrate is of silicon, silicon covered with a molybdenum film, or standard glass covered with a molybdenum film.

10. Process according to any one of the preceding claims used for producing large-size, flat screens.

FIG. 1

FIG. 2

FIG. 3

FIG. 4